Europäisches Patentamt

(19) European Patent Office

Office européen des brevets

(11) Publication number: **0 104 331**
**A2**

(12) **EUROPEAN PATENT APPLICATION**

(21) Application number: **83106396.1**

(22) Date of filing: **30.06.83**

(51) Int. Cl.³: **H 01 J 37/32**
**H 01 L 21/306**

(30) Priority: **06.07.82 US 395523**

(43) Date of publication of application:
**04.04.84 Bulletin 84/14**

(84) Designated Contracting States:
**DE FR GB NL**

(71) Applicant: **THE PERKIN-ELMER CORPORATION**
**Main Avenue**
**Norwalk Connecticut 06856(US)**

(72) Inventor: **Bruce, Richard H.**
**200 Bently**
**Mountain View California(US)**

(72) Inventor: **Reinberg, Alan R.**
**2 Charberth Lane**
**Westport Connecticut(US)**

(74) Representative: **Patentanwälte Grünecker, Dr.**
**Kinkeldey, Dr. Stockmair, Dr. Schumann, Jakob, Dr.**
**Bezold, Meister, Hilgers, Dr. Meyer-Plath**
**Maximilianstrasse 58**
**D-8000 München 22(DE)**

(54) Controllable dry etching technique, and apparatus.

㊿ Plasma etching is selectively varied between isotropic and anisotropic modes through exercise of control over the frequency fo the plasma excitation potential.

FIG. 1

**0104331**

PATENTANWÄLTE
GRÜNECKER DR MÜLLER DR STOCKMAIR
DR SCHUMANN JAKOB DR BEZOLD MEISTER
HILGERS DR MEYER-PLATH
MAXIMILIANSTR. 58 · 8000 MÜNCHEN 22

## BACKGROUND OF THE INVENTION

### (1) Field of the Invention

The present invention relates to dry etching and particularly to a plasma etching technique wherein the rate and direction of the etching is controlled to achieve a desired etch profile. More specifically, this invention is directed to apparatus for controlling a dry etching procedure to selectively accomplish isotropic or anisotropic etching modes. Accordingly, the general objects of the present invention are to provide novel and improved methods and apparatus of such character.

### (2) Description of the Prior Art

Plasma etching is a well known technique which is, by way of example, used in the fabrication of integrated circuits. In plasma etching a gas, which has been dissassociated into positive and negative radicals, reacts with and removes unprotected areas of a material. In the field of solid state electronics, the material to be etched will typically be in the form of a layer which has been deposited on a substrate. The plasma is produced by subjecting the gas, which is confined in a chamber at a relatively low internal pressure, to an r.f. field.

Plasma etching procedures remove the "target" material either isotropically or anisotropically.

**0104331**

Isotropic etching results in the non-directional removal of the material and results in a profile wherein the material being etched is undercut beneath the protective coating. Anisotropic etching is the unidirectional removal of the material and results in an etch profile having sharp edges and vertical walls.

Neither of the above-described etched profiles are desirable for certain applications. This is especially true when the pattern to be etched is to subsequently be convered by a protective coating by means of a deposition method. With an undercut profile, the subsequently deposited coating material may not fully cover the surface of the etched pattern. Conversely, the sharp edges of an anisotropically etched pattern may cause failure of the protective coating.

This failure of or incomplete covering of the etched pattern becomes exceedingly important as the dimensions of the etched areas or traces, conductive paths for example, are reduced along with the reduction of the spacing between adjacent traces. The result may be undesirable arching or shorting between adjacent conductive regions or enhanced failure at the thinly covered areas, particularly at the sharp edges or along vertical walls.

### SUMMARY OF THE PRESENT INVENTION

The present invention overcomes the above-discussed disadvantages and other deficiencies of the prior art by providing a dry etching method, and apparatus for use in the practice thereof, wherein the raised profile produced by the etching technique may be controlled.

The present invention is thus a method of an apparatus for regulating the etching of a material between the isotropic and anisotrapic modes. Isotropic etching, it is to be noted, is a function of a chemical process by which free radicals or non-directed ions attack the material to be etched in random directions. Anisotropic etching is a chemical process which is enhanced by directed ion bombardment so that the etching proceeds more rapidly in a vertical direction to such an extent that any lateral etching is insignificant.

It has been determined that anisotropic etching is achieved at low excitation frequencies. Accordingly, etching is controlled by regulating the plasma producing excitation frequency to obtain the desired mode of etching. This manner in which this frequency regulation is effected is dependent upon the specific etching gas. It has been determined that when the excitation frequency is reduced below 1 MHz in several etching systems, this frequency being coincident with an ion cutoff frequency which will be more fully discussed herein, the resulting mode of etching is anisotropic.

The present invention, through exercising control over excitation frequency, regulates the etching mode to achieve a desired profile. The etching is preferable controlled to achieve a profile which has a rounded upper corner.

## BRIEF DESCRIPTION OF THE DRAWING

The present invention may be better understood and its numerous objects and advantages will become apparent to those skilled in the art by reference to the accompanying drawing wherein:

Figure 1 is a schematic diagram of apparatus in accordance with the invention;

Figure 2A and 2B are cross-sectional views of etched profile;

Figure 3 is a graph showing the ion transition frequency for an argon-kryton gas; and

Figure 4 is a graph showing the potential oscillation of a plasma as a function of the applied voltage.

## DESCRIPTION OF THE PREFERRED EMBODIMENT

As previously noted, the present invention relates to a method of exercising control over a dry etching process by regulating excitation frequency and thus etching mode. The exercise of control over the etching mode, in turn, results in the control of the profile of the etched material whereby a desired configuration may be achieved. The desired profile will typically be characterized by sloped sides. In the practice of the present invention the output frequency of the r.f. voltage source which supplies the plasma excitation potential is adjusted above and below the ion cut-off or transition frequency for the particular etchant gas.

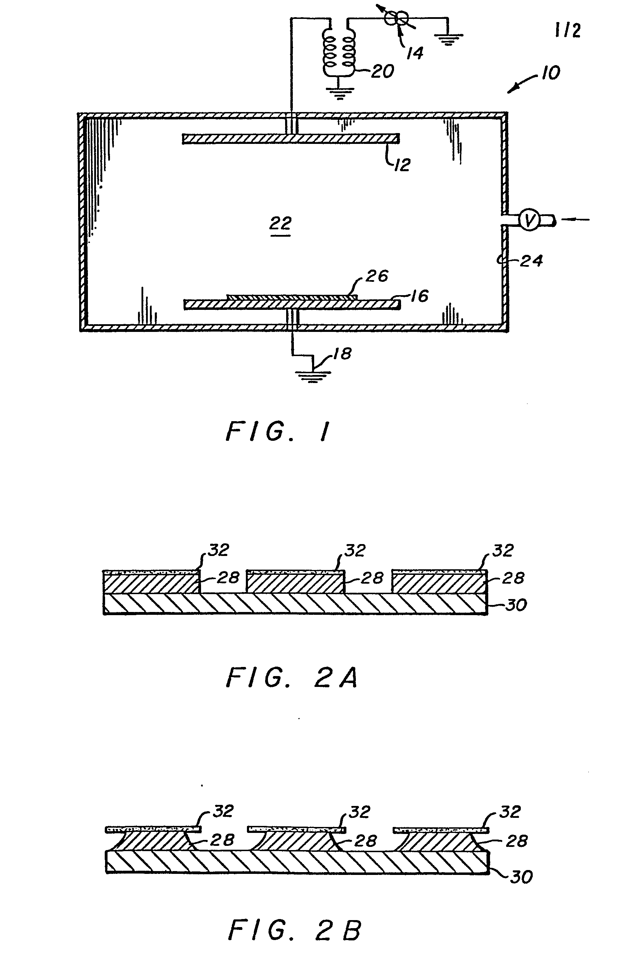

Referring to Figure 1, a reactor useful in the practice of the present invention is indicated generally at 10. Reactor 10 is a parallel electrode reactor with upper electrode 12 connected to a variable frequency r.f. power supply 14 which is typically capable of applying r.f. power in the range of zero to 300 watts over a frequency range of between 100 KHz and 13 MHz. The lower electrode 16 is directly grounded at 18 while upper electrode 12 is grounded through the secondary winding of an autotransformer 20. Various types of r.f. power supplies are, of course, available for use in the practice of the invention.

A plasma is created in the chamber 24 of reactor 10, in the space 22 between electrodes 12 and 16, by supplying an etchant gas to the chamber and establishing a field between electrodes 12 and 16 which varies at a frequency in the r.f. spectrum. The gas may be continuously supplied by appropriate control systems such as rotameters, mass flow controllers or fixed orifices. The pressure within the chamber 24 is maintained at between 150 to 2500 millitorrs, depending upon the type of gas employed and will preferably be 500 millitorrs with $Cl_2$ as the etchant gas and a 1cm spacing between the electrodes.

Etchant gases that may be utilized in the practice of the present invention may be selected from the following: $C_3F_8$, $CHF_3$, $Cl_2$, $CCl_4$, $CF_4$, $C_2CL_4$, $F_2$, other halogenated gases, and oxygen, all of which may be diluted with inert gases such as Ar or He.

The electrical field established between electrodes 12 and 16 forms the plasma by causing, in the manner known in the art, ionization of the supplied gas, the ionization creating positive and negative ions along with radical neutral species. The radicals, along with the ions, are responsible for attacking and etching the unprotected portions of a body 26, which is positioned upon lower electrode 16.

For purposes of explaining the present invention, and referring to Figure 2, body 26 to be etched may be considered to be comprised of a layer of doped poly-silicon 28 which has been formed on a silicon-oxide substrate 30. The poly-silicon layer is protected from attack by the free radicals and ions in preselected regions by an etch-resist 32 which may comprise a layer of oxide. Etch resistant coatings suitable for use in the practice of the present invention include Shipley 1300 and 1400 series resists and those made by the Hunt Chemical Company. It should be noted that any material which lends itself to both ion and chemical etching may be controllably etched by use of the present invention.

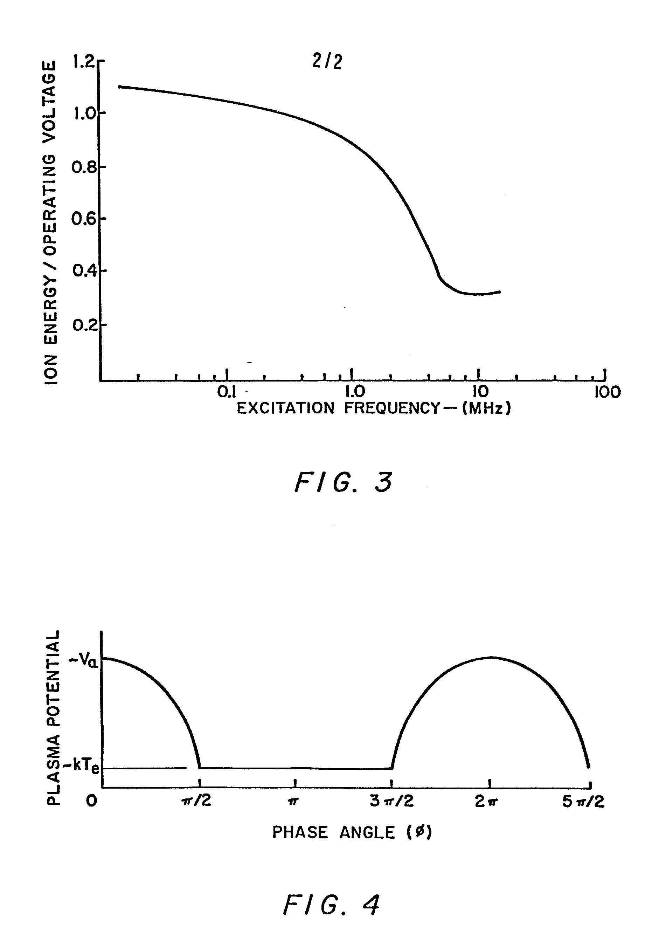

The plasma potential, p, will vary as a function of the applied voltage as indicated by Figure 4. The plasma always assumes the most positive potential with respect to the rest of the reactor system and oscillates coherently with the applied voltage. It is known that a plasma sheath, not shown, forms between the plasma and each of the electrodes 12 and 16. This sheath functions as a large impedance across which most of the voltage will appear. This sheath acts as a region through which the free radicals may pass and through which the ions are accelerated in order to reach and attack the body 26.

EO-2753

**0104331**

The ion bombardment energy is affected by the excitation frequency in two ways. First, as the excitation frequency is lowered, e.g., from 13 MHz to 1 MHz, the operating voltage is observed to increase causing higher ion bombardment energy. Secondly, when the excitation frequency is "low", ions will cross the sheath and will bombard the electrode with an energy equal to the full plasma potential. At higher frequencies, i.e., at frequencies above the ion transition frequency for the particular system, the ions will have only an average of the plasma potential and thus lower energy. It has been determined, for reasons still not clear, that bombardment by the ions at the full plasma potential energy level caused an enhanced etching mechanism in a vertical direction, i.e., an anisotropic etch.

To restate the above, the kinetic energy of an ion reaching the grounded electrode depends on whether it moves across the sheath slowly or quickly relative to the oscillating plasma potential. If the ions move quickly, then the maximum possible energy is the maximum plasma potential which is approximately equal to the amplitude of the voltage $V_2$ applied to electrode 12. If the ion is slow, then it will have maximum energy equal to a time averaged value of the plasma potential. Since the plasma potential is pinned just above ground for the negative half cycle, the average potential is $v_a/\pi$ for a sinusoidal response during the positive half cycle. The ions respond directly to the r.f. field at low excitation frequencies and only to an average of the field at high frequencies. Therefore, by lowering the excitation frequency, the ion energy can increase through two mechanisms: first the operating voltage increases and, secondly, the ions begin to respond to the r.f field and consequently the energy transfer becomes more
efficient.

Figure 3 represents the measured ratio of the
ion energy to the amplitude of the applied voltage as a
function of frequency. Specifically, the maximum
energy for positve krypton ions was measured by
creating a plasma form a 5% concentration of krypton-
argon gas. This measurement was performed in a
parallel plate etching reactor with an electrode
spacing of 1 cm with an internal pressure of 300
millitorr. The reactor was connected via a pinhole,
having a diameter of 1.5 X 10 - 3 inches, to a
differentially pumped chamber containing a mass
spectrometer.

The ion transition frequency for this
particular gas is approximately 4 MHz for the
conditions present in the reactor as discussed above.
The ion transition frequency for a given gas system
must be determined, for example through tests, and is
influenced by ion mass and collision cross-sections.

Once the ion transition frequency is
determined the mode of etching can be controlled by
adjustment of the excitation frequency. Referring to
Figures 2A and 2B, the resulting profiles for the
selected etching modes are seen. The etched bodies are
comprised of a doped poly-silicon layer 28 which was
deposited upon a silicon-oxide layer 30, with a layer
32 of silicon-oxide grown on layer 28 and being
employed to define the desired etch pattern.

The substrates were etched in a parallel
plate reactor with 1 cm electrode spacing with $Cl_2$ as
the etchant gas. The pressure within the reactor was maintained at 300 millitorr while the voltage applied
to the driven electrode had an amplitude of 500 volts
with 50 watts of 100 KHz excitation. The ion
transition frequency for the $Cl_2$ gas under the above
conditions was 4 MHz.

The profile shown in Figure 2A was obtained
by maintaining the frequency at 100 KHz, the resulting
etching mode being anisotropic. By raising the
excitation frequency to 13.5 MHz the resulting etching
mode was made isotropic with the resulting profile
being seen in Figure 2B. Unlike the etched profile of
Figure 2A, which had straight side walls, the profile
of Figure 2B exhibits undercutting beneath the
protective layer 32.

The proper maintenance time of the excitation
frequency above the ion transition frequency to obtain
a desired amount of isotropic etching for a given gas
is dependent upon the rate of etch for the gas
radicals. This role depends on the particular etching
system. The concentration of radicals depends on
discharge conditions such as r.f. power, pressure,
excitation frequency, and chamber materials. The
desired results can be achieved through maintaining
constant all variables for a given etching process and
then varying the excitation frequency to obtain the
proper degree of isotropic ethcing. This relationship
between the variables for a particular etching
arrangement may be determined empirically.

Desired profile control can be achieved by
initially etching isotropically at high frequencies to
achieve a rounding of the profile edge and then etching
anisotropically at low frequencies to maintain proper
line width control.

In addition to increased vertical ethcing of excitation frequencies below the ion transition frequency, reduced chemical isotropic ethcing is also observed. In several etching systems, such as $Cl_2$ and doped poly-silicon, the isotropic etching is essentially eliminated relative to the vertical etching. This condition allows vertical etch profiles to be achieved even with overetching.

Profile control of etched features can be be achieved by varying excitation frequency. High frequency etching, i.e., operation above the ion transition frequency, has been observed to be isotropic in several systems while-low frequency etching below the ion transition frequency is perfectly anisotropic. A high frequency etch followed by a low frequency etch will therefore provide a profile with the desirable rounded corner but without a serious loss of line width.

While a preferred embodiment has been shown and described, numerous modifications and substitutions may be made thereto without departing from the spirit and scope of the invention. Accordingly, it is to be understood that the present invention has been described by way of illustration and not limitation:

## WHAT IS CLAIMED IS:

1. A method of controllably etching a material to obtain a desired etch profile comprising the steps of:

comprising the material to be etched in a chamber on a first electrode;

establishing a preselected pressure of an etchant gas in the chamber, a second electrode being disposed in the chamber and spaced from the first electrode;

establishing a periodic electrostatic field which varies at a rate within the radio frequency spectrum between the electrodes to thereby create a plasma; and

varying the frequency of the field to selectively cause isotropic or anisotropic etching.

2. The method of Claim 1 wherein the frequency of the field is varied to above and below the ion transition frequency of the system to respectively produce isotropic and anisotropic etching.

3. The method of Claim 2 wherein frequency is varied within the range of 100 KHz to 13.5 MHz

4. The method of Claim 2 wherein the established pessure is in the range of 150 to 2500 millitorrs.

0104331

5. The method of claim 3 wherein the established pressure is in the range of 150 to 2500 millitorrs.

6. The method of Claim 2 wherein the gas is chlorine and the ion transition frequency is 4 MHz.

7. The method of Claim 2 wherein the isotropic etching is performed before the anisotropic etching and said method further comprising the step of:

defining a pattern to be etched by means of discontinuous protective coating on the material to be etched.

8. Apparatus for controllably dry etching materials comprising:

a hermetically sealed chamber;

a pair of parallel spacially displaced electrodes disposed in said chamber;

means for controllably supplying an etchant gas to said chamber; and

means for establishing a variable frequency radio frequency potential between said electrodes.

9. The apparatus of Claim 8 wherein a fisrt of said electrodes is connected to ground potential and the potential establishing means is connected to the second of said electrodes.

10. The apparatus of Claim 9 wherein said potential establishing means comprises a variable source of radio frequency power.

1/2

FIG. 1

FIG. 2A

FIG. 2B

2/2

FIG. 3

FIG. 4